# EUROPEAN PATENT APPLICATION

(11) **EP 0 846 786 A2**
(43) Date of publication of application: **10.06.1998**
(21) Application number: 97309543.3
(22) Date of filing: 26.11.1997
(51) Int. Cl.: C23C 14/35, H01J 37/34, H01L 21/285

(54) **Modified physoical vapor deposition chamber and method of depositing materials at low pressure**

(30) Priority: 06.12.1996 US 761584
(71) Applicant: Applied Materials, Inc., Santa Clara, California 95054 (US)
(72) Inventor: Fu, Jianming, San Jose, CA 95124 (US); Satitpunwaycha, Peter, Santa Clara, CA 95129 (US); Ding, Peijun, San José, CA 95129 (US); Cruz, Joe G., San Jose, CA 95131 (US); Xu, Zheng, Foster City, CA 94404 (US)
(74) Representative: Bayliss, Geoffrey Cyril

(57) **Abstract**

A conventional sputtering chamber (100) is modified by providing a target extension (102) that surrounds the plasma region (110) and confines electrons to the plasma. This enhancement of confinement of the plasma reduces the pressure needed to maintain the plasma. At low pressures, reduced scattering of sputtered species takes place and more sputtered particles arrive vertically at the substrate (108), improving the filling of high aspect ratio openings in the substrate.

## Description

This invention relates to apparatus and method for sputter deposition. More particularly, this invention relates to a modified physical vapor deposition apparatus which permits deposition at low pressures.

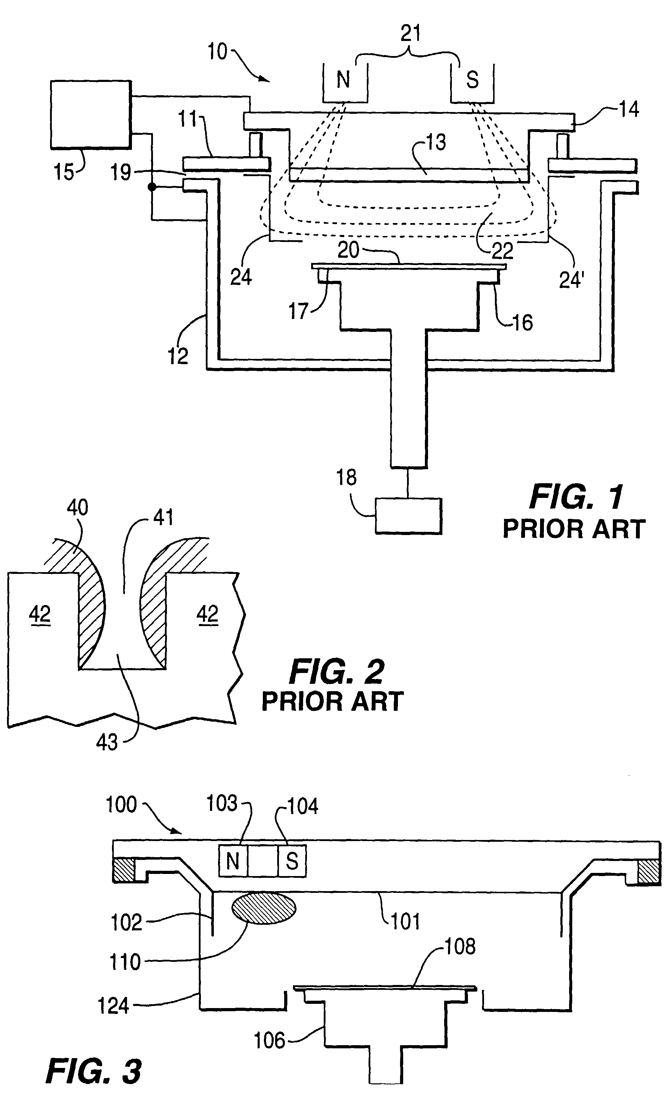

Sputter deposition of materials such as titanium, titanium tungsten, titanium nitride, aluminum, aluminum alloys, tungsten, tungsten silicide, molybdenum silicide, silicon and copper and copper alloys, is conventional. A typical physical vapor deposition chamber (PVD) is shown schematically in Fig. 1.

Referring to Fig. 1, a chamber 10, having a top wall 11 and a sidewall 12, includes a target 13 made of the material to be sputtered, or a precursor thereof. The target 13 is mounted on a target support 14 which is connected to a source of power 15. A susceptor 16 for supporting a substrate 20 to be sputtered is mounted so that its top surface 17 is parallel to and spaced from the target 13. The susceptor 16 is also connected to a power source 18. A gas inlet port 19 permits a reactive and/or inert gas, such as argon, to be added to the chamber 10.

A magnet pair 21 is mounted behind the target 13. This magnet pair 21 creates a magnetic field about the outer circumference of the target 13 that helps to confine the plasma above the susceptor 16. The magnetic pair 21 forms an orthogonal electromagnetic field 22, shown in dashed lines, between the target 13 and the susceptor support 16, thereby enhancing the plasma density and improving sputtering efficiency by increasing the deposition rate without adversely affecting the quality of the sputtered films.

When a gas flow is started in the chamber 10, the inert gas molecules in the region between the target 13 and the susceptor 16 become ionized and strike the surface of the target 13, displacing molecules of the material of the target 13 which deposit onto the substrate 20.

However, since sputtered material scatters in random directions, the sputtered material deposits not only on the substrate 20, but also on the walls 11, 12 and fixtures inside the chamber 10. Thus it is also conventional to mount a shield 24 about the periphery of the target 13 that extends toward the substrate 20. Scattered sputtered material deposits on the shields 24, 24', rather than on the walls 11, 12 of the chamber 10, reducing the need to clean the chamber walls. Various methods are known to clean the shield 24, 24' periodically to remove these deposits, or the shields 24, 24' can be replaced at intervals.

With the advent of micron and submicron design rules, openings in the substrate into which contact materials, such as aluminum, are to be sputtered are becoming smaller, and the aspect ratio of these openings, i.e., the ratio of the depth to the diameter of the opening, is becoming higher. Sputtered material in a PVD chamber scatters in random directions from the target, and it is difficult to fill such small openings because very few sputtered particles impact the substrate in a vertical direction. Thus most of the sputtered material deposits on the top and sidewall surfaces of the openings in a substrate, rather than on the bottom of the openings. This causes the top of the deposits to bridge over the opening, leaving a void as shown in Fig. 2. In Fig. 2 an aluminum layer 40 is shown deposited into a high aspect ratio opening 41 in a silicon substrate 42, leaving a void 43.

It is also known that more bottom filling can be achieved at lower pressures than at higher pressures. However, it is very difficult to maintain a plasma at pressures much below about 1 millitorr. Referring again to Fig. 1, the magnetic field 22 at the periphery of the target 13 is superimposed on the shield 24, 24'. Electrons that escape from the plasma impact the shield 24, 24', where they are lost. If a high percentage of electrons are lost under low pressure, thin plasma operating conditions result and the plasma becomes extinguished.

Thus it would be highly desirable to provide a sputtering chamber in which a plasma can be maintained at low pressures so that high aspect ratio openings can be filled without the formation of voids.

In accordance with the present invention, a PVD chamber is modified to extend the cathode (the target), thereby changing the electrical field near the plasma region to enhance confinement of electrons within the plasma region. This in turn reduces the amount of gas pressure needed to sustain the plasma, thereby reducing scattering of sputtered species and improving filling of high aspect ratio openings.

The following is a description of a specific embodiment of the invention, reference being made to the accompanying drawings, in which

Fig. 1 is a schematic view of a physical vapor deposition chamber of the prior art having a shield therein.

Fig. 2 is a cross sectional view of a partially filled opening in a substrate using a physical vapor deposition chamber of the prior art.

Fig. 3 is a schematic view of a region of a physical vapor deposition chamber illustrating the present invention.

Applicants' invention will be further described referring to Fig. 3. Fig. 3 illustrates a portion of a physical vapor deposition chamber 100 having a target 101 having extensions 102. The chamber 100 also includes magnets 103 and 104 mounted behind the target 101, a susceptor 106 for supporting a substrate 108, and a shield or anode 124. The cathode 101 is extended to change the electrical field near the plasma region 110 with respect to the anode 124. The target extension 102 is at the same potential as the target 101, and thus increases the electrical field in this region. This increased electrical field has a high negative potential, which in turn drives electrons, which have a negative charge, that have escaped from the plasma back into the plasma region 110. Thus the confinement of electrons in the plasma is increased. The result is that a plasma can be maintained in the chamber 100 at low chamber pressures without being extinguished.

The target extension 102 will become coated by the material sputtered from the target 101, and in turn the target material may be sputtered off the target extension 102. However, the rate of sputtering off the target extension 102 will be lower than the sputtering rate at the target face 101 below the magnets 103, 104. Further, the deposition rate onto the extension 102 is higher than the sputtering rate of the material used to make the extension 102. Thus a net deposition of target material will be deposited on the target extension 102. Therefore, during the sputtering process, any material sputtered onto the substrate 108 from the target extension 102 will be target material, rather than material sputtered from the target extension 102 itself. Thus the target extension 102 will not contaminate the substrate 108.

The target extension 102 may be part of the target 101, or may be a separate piece whose bias may be independently controlled if desired. The position of the shield or anode 124 in the PVD chamber 100 can also be changed, and the shape can be changed, as is known to those skilled in the art. However, a strong electrical field is still generated at the target extension 102, with the results as explained hereinabove.

Thus although the invention has been disclosed in terms of specific embodiments, various changes to the equipment can be made and are meant to be included herein. The invention is only meant to be limited by the appended claims.

## Claims

1. In a physical vapor deposition chamber comprising a cathode target, an anode shield, a substrate support and a pair of magnets mounted behind the target, the improvement comprising a target extension that confines electrons to the plasma region.

2. A chamber according to claim 1 wherein the target extension is negatively charged.

3. A method for reducing the pressure required for maintaining a plasma in a physical vapor deposition chamber comprising extending the target about the plasma region to confine electrons to the plasma.

4. A method according to claim 3 wherein the target extension is negatively charged.

5. A method of improving the filling of high aspect ratio openings in a substrate by sputtering comprising extending a sputtering target about the plasma region to confine electrons to the plasma, thereby reducing the pressure needed to maintain the plasma and reducing the scattering of sputtered species, thereby increasing the number of sputtered particles that impact the substrate vertically.

6. A method according to claim 5 wherein the target extension is negatively charged.
